Europäisches Patentamt

European Patent Office

Office européen des brevets

(11) Publication number: 0 519 147 A1

# EUROPEAN PATENT APPLICATION

(21) Application number: 91810470.4

(22) Date of filing: 19.06.91

(51) Int. Cl.⁵: H01L 39/24

(43) Date of publication of application:
23.12.92 Bulletin 92/52

(84) Designated Contracting States:
DE FR GB

(71) Applicant: International Business Machines
Corporation
Old Orchard Road
Armonk, N.Y. 10504(US)

(72) Inventor: Anselmetti, Dario, Dr.
Feldstrasse 24
CH-4123 Allschwil(CH)
Inventor: Bednorz, Johannes Georg, Dr.
Herschärenstrasse
CH-8633 Wolfhausen(CH)
Inventor: Gerber, Christoph Emanuel, Dr.
Im Gruet 2
CH-8805 Richterswil(CH)
Inventor: Mannhart, Jochen, Dr.
Alte Landstrasse 131
CH-8804 Au/ZH(CH)
Inventor: Müller, Carl Alexander, Prof. Dr.
Haldenstrasse 54
CH-8908 Hedingen(CH)
Inventor: Schlom, Darrell, Dr.
Mythenstrasse 8
CH-8800 Thalwil(CH)

(74) Representative: Rudack, Günter O., Dipl.-Ing.
International Business Machines Corp.,
Säumerstrasse 4
CH-8803 Rüschlikon(CH)

(54) Method for controlling the current density tolerance of high-Tc-superconductors.

(57) This method for controlling the current density tolerance of high-$T_c$ superconductors is based on the existing correlation between the number of screw dislocations in the lattice of the superconductor material and the maximum current density the material can tolerate before turning normal conductive. The controlled introduction into the superconductor material of a predetermined number of dislocations and associated pinning centers within the lattice of the superconductor material is proposed to be made through the appropriate adjustment of certain growth parameters of the epitaxial crystal growth process.

Preferably, the superconductor material is grown onto the (100) surface of a crystalline substrate (7a...7c) whose lattice constant is reasonably close to the lattice constant of the superconductor material. The epitaxial growth process may be controlled as to growth rate, as to temperature of the substrate holder (6), and as to tilt angle the surface of the substrate has towards the ⟨111⟩ and/or ⟨100⟩ directions with respect to its (100) orientation. During the growth process, all of the other growth parameters are maintained at their set values.

FIG. 5

This invention relates to a method for introducing dislocations into high-$T_c$ superconductors as pinning centers for pinning the vortices of flux quanta in order to control the current density tolerance of the superconductor material. The invention is applicable to perovskite-related materials such as, e.g. $YBa_2Cu_3O_{7-\delta}$ , and it is of particular interest in the case of more anisotropic superconductors, such as $Bi_2Sr_2Ca_{n-1}Cu_nO_x$ and $Tl_{1...2}Ba_2Ca_{n-1}Cu_nO_x$ , for example.

It is well known that for high-field, high-current applications of type II superconductors, pinning sites are necessary to pin the vortices, thus preventing flux creep or flux flow from causing resistive losses within the material. Below the critical temperature $T_c$, so-called pinning centers control the maximum current density a superconductor can support without becoming electrically resistant. For current densities higher than this "critical" current density $J_c$, the superconductor material is resistive and a voltage V can develop along the superconductor. The strength of the pinning centers depends on the concentration of free charge carriers in the superconductor material and can, therefore, be controlled by the variation of the carrier concentration with an applied electrical field, for example. This effect is used in the field-effect transistor described in EP-A- (91810006.6).

Candidate defects in the generation of pinning centers are point defects, line defects, planar defects, and three-dimensional inclusions. Because of the short coherence length of high-$T_c$ superconductors, the latter two types of defect pinning centers can seriously degrade the critical current by considerably reducing the area available for current flow.

For the non-dissipative operation of superconductors, pinning energies significantly greater than the thermal energy ($k_BT$) are required. Measurements of the pinning energies in high-$T_c$ superconductors have shown that the pinning energy decreases as the anisotropy ($\xi_{ab}/\xi_c$) increases. This has led to the conclusion (cf. T.T.M. Palstra et a., "Role of anisotropy in the dissipative behavior of high-temperature superconductors", Phys. Rev. B, Vol. 43, No. 4 (1991) pp. 3756-3759) that the use of anisotropic high-$T_c$ superconductors at moderate temperatures (i.e. moderate on the scale of $T_c$) in high magnetic fields is impractical. This conclusion is based on the measurement of pinning energies in bulk-grown single-crystals of high-$T_c$ superconductor compounds where point defects are believed to be the dominant pinning sites.

It is known that epitaxial films of high-$T_c$ superconductors have impressive critical current densities of $\simeq$ $6 \times 10^6$ A/cm$^2$ at 77 K. Chaudhari et al., in "Earlier and Recent Aspects of Superconductivity", Springer Series in Solid-State Sciences, Vol. 90, Springer-Verlag, Berlin 1990, pp. 201-207, have pointed out that for current densities of such an order of magnitude, strong pinning centers for the magnetic flux quanta are required. The authors suggested the existence of pinning sites at the location of dislocations.

By imaging epitaxial $YBa_2Cu_3O_{7-\delta}$ material with a scanning tunneling microscope, Ch. Gerber et al., "Screw dislocations in high-$T_c$ films", Nature, Vol. 350 (1991) pp. 279-280, observed screw dislocations with densities of $\simeq 10^9$/cm$^2$. The concentration of these screw dislocations exceeds that in the substrates by three to four orders of magnitude, suggesting that high dislocation densities are an intrinsic property of sputtered high-$T_c$ superconductor films.

In view of the fact that the capability of high-$T_c$ superconductor films to tolerate high current densities depends on the density of dislocations within the superconductor material, it is an object of the present invention to teach ways for increasing the dislocation density so as to optimize the current density tolerance of the superconductor material.

In accordance with the invention, this is achieved by a method for controlling the current density tolerance of high-$T_c$ superconductors through the introduction into the superconductor material of a predetermined number of dislocations and associated pinning centers within the superconductor material through appropriate adjustment of certain growth parameters thereof, the method being characterized by providing a crystalline substrate, said substrate having a low-index crystallographic surface onto which the high-$T_c$ superconductor material is to be epitaxially grown, and by adjusting one or more of the parameters growth rate, growth temperature, and substrate tilt angle, respectively, to a predetermined constant value during the growth of the superconductor crystal, while keeping all of the other growth parameters at their set values.

The ability to control the density of effective pinning centers (i.e. screw dislocations) is not only important for the $YBa_2Cu_3O_{7-\delta}$ type of material, but is particularly essential for more anisotropic high-$T_c$ superconductor materials, such as, e.g., $Bi_2Sr_2Ca_{n-1}Cu_nO_x$ and $Tl_{1...2}Ba_2Ca_{n-1}Cu_nO_x$ which have higher critical temperatures. If used with anisotropic materials, the pinning centers can greatly extend the ranges of temperature and magnetic field in which components made of those anisotropic materials can operate.

Details of the inventive method will hereafter be described by way of example and with reference to the accompanying drawings in which.

Fig. 1    shows the relation between the critical current density and the screw dislocation density;

Fig. 2    shows the density of screw dislocations in dependence on the growth rate;

*Fig. 3*    shows the dependence of the density of screw dislocations on the growth temperature;

*Fig. 4*    shows the screw dislocation density versus the tilting angle of the substrate;

*Fig. 5*    is a cross section through a sputtering chamber for performing the inventive method.

The mechanism permitting the generation of high densities of screw dislocations in $YBa_2Cu_3O_{7-\delta}$ films is of particular interest since its understanding may lead to the controlled introduction of these defects. Possible dislocation introduction mechanisms include inheritance from the substrate, generation by the formation of dislocation half-loops, or by the incoherent meeting of growth fronts. Inheritance from the substrate may be ruled out since the dislocation density in the usual substrates is several orders of magnitude lower than the $\approx 10^9/cm^2$ screw dislocations observed in these films.

Stacking faults are known to be quite common in $YBa_2Cu_3O_{7-\delta}$ films prepared by sputtering and laser ablation, and structural edge dislocations with Burgers vector b = c[001] have been observed in laser-ablated films. A stacking fault or impurity phase could give rise to a dislocation half-loop which contains a pure edge segment parallel to the plane of the substrate, and which emerges from the surface of the film as two screw dislocations of opposite sign. However, cross-sectional images of these films do not show the presence of a high density of dislocation half-loops, indicating that this is not the mechanism of screw dislocation production either. The incoherent meeting of growth fronts has been observed to produce screw dislocations which then act as growth centers in the growth of synthetic micas. An analogous process may occur in $YBa_2Cu_3O_{7-\delta}$ films in their early stages of growth.

One screw dislocation generation mechanism described by A. Baronett in Journ. of Crystal Growth, Vol. 19 (1973) pp. 193-198, involves the blocking of an advancing growth front by an obstacle, e.g. an impurity. As a result of being blocked, the growth front is divided into two branches which continue to grow and eventually meet up with each other. The reunion of the two branches determines whether a screw dislocation is generated. In the case where the growth front is advancing in a horizontal plane, when the two branches meet and recombine with an offset in their vertical positions and their horizontal axes aligned, a screw dislocation is produced. The sign of the screw dislocation depends on which recombining branch is higher. In the case of a vertical offset and recombination of the branches with non-aligned horizontal axes, a twist boundary will exist at the interface between the recombined branches, and further growth will not be favored.

This generation mechanism is advantageous for layered substances which are capable of flowing over irregularities - giving rise to the vertical misalignment when branches reunite - while retaining their crystalline structure. Synthetic micas are clearly able to grow this way. Also $YBa_2Cu_3O_{7-\delta}$ films have been found to be capable of bending over surface irregularities on the substrate.

In the growth of $YBa_2Cu_3O_{7-\delta}$ films, screw dislocations may be generated during the initial stages of substrate coverage and island coalescense by a generation mechanism analogous to that observed in micas. Transmission electron microscope images of $YBa_2Cu_3O_{7-\delta}$ films indicate that a high density of threading defects, including dislocations, is generated in the vicinity of the substrate.

In a test experiment, the dislocation density of a film with faceted growth spirals was found to be comparable to that of films for which growth was started at a substrate heater block temperature of 760°, and where the major part of the film growth process occurred at 700°. This observation is consistent with the assumption that screw dislocations are generated during the process of island coalescense, and that the growth temperature is a determining factor in dislocation generation.

The coalescense of nuclei that occurs during the initial stages of growth on a foreign substrate surface not perfectly lattice-matched to the deposited overlayer is known to result in the generation of dislocations owing to rotational or translational misalignment of the impinging nuclei. In an analogous manner, during screw dislocation-mediated growth, misalignments of impinging terraces of growth spirals may occur, leading to the generation of defects. These defects include not only dislocations and point defects acting to accommodate in-plane misalignments of the coalescing terraces, but if the joining terraces are offset from one another along the c-axis, an out-of-phase boundary may occur when they unite.

Out-of-phase boundaries are common in sputtered and laser-ablated $YBa_2Cu_3O_{7-\delta}$ films, and they may occur also at the intersections of growth spirals. The lattices of intersecting growth spirals are offset from one another along the c-axis.

These various defects at the periphery of growth spirals, which presumably are correlated with the screw dislocation density because of the film growth mechanism, are potential vortex pinning sites. The implied vortex pinning structure consists of strong pinning at screw dislocations, each of which is encompassed by a multitude of weaker pinning sites.

Thin $YBa_2Cu_3O_{7-\delta}$ films (with $\delta$ being between zero and 1) are usually grown by either of two conventional processes: DC hollow cathode magnetron sputtering or laser ablation. The sputtered films may be grown on atomically flat polished low-index sufaces, such as (100) surfaces, for example, of undoped or

Nb-doped $SrTiO_3$ substrates having a dislocation density of $1...50 \times 10^5/cm^2$ . Except for the sputter rate, which is varied by adjusting the plasma discharge between 150 V and 180 V and 260-500 mA, corresponding to growth rates between 0,01 and 0,5 nm/s, the sputtering parameters are kept at constant values as follows: Heater block temperature of 750°C, total ambient pressure ($Ar/O_2$ = 2:1) of 0,87 mbar, and aftergrowth cool-down in a 0,5 bar $O_2$ atmosphere lasting for about one hour.

It should be noted that considerably higher growth rates than those obtained with hollow cathode magnetron sputtering are possible with conventional pulsed-laser deposition techniques. The growth rate can even reach values on the order of 1 $\mu$m/s with those techniques. The adjustment of the growth rate is then made by controlling the duration of the laser pulses.

H.P. Lang et al. "Atomic resolution and nanostructure of $YBa_2Cu_3O_{7-\delta}$ laser ablated thin films studied by scanning tunneling microscopy (STM)", to be published in Europhysics Letters, have observed that laser-ablated $YBa_2Cu_3O_{7-\delta}$ films grown on $SrTiO_3(100)$ , MgO (100) and $LaAlO_3(100)$ substrates contain high densities of screw dislocations. With the substrates rinsed and attached to a heater block, ablation is performed with a KrF excimer laser radiating a $YBa_2Cu_3O_{7-\delta}$ target at an energy density of 2 $J/cm^2$ and with a 3...10 Hz pulse rate in a growth chamber containing 0,26 mbar $O_2$. The target is rotated during deposition and polished to an optical smoothness between growth runs to minimize "boulders" in the laser-ablated films. After growth, the samples are cooled to 450° in $\simeq$ 2,6 bar $O_2$ for 30 minutes, held at this temperature for another 30 minutes, and then slowly cooled down to room temperature under flowing oxygen.

There is an inherent similarity between the surface morphology of sputtered and laser-ablated $YBa_2Cu_3O_{7-\delta}$ films, indicating that for these two growth processes the same growth mode is operative. Irrespective of the particular manufacturing method, therefore, the characteristics of the films grown are widely the same: It may be expected that superconductor films prepared with the above-described methods will have a critical temperature $T_c$ of about 90 K and a critical current density $J_c$ = $1...8 \times 10^6$ $A/cm^2$ at a temperature of 77 K and $1...7 \times 10^7$ $A/cm^2$ at 4,2 K (1 $\mu$V criterion in self-field). Viewing such a film with a scanning tunneling microscope (tunneling current $I_T$ = 10...300 pA, tip bias voltage $V_t$ > 0,5...1 V, $Pt_{0,80}Ir_{0,20}$ tips, room temperature, in air) reveals a striking arrangement of a multitude of dislocations with screw-like, atomically flat terraces centered around those dislocations. The number of turns of these screws depends on the thickness of the film: Thin films (12 nm) have one or a few turns, thick films (150 nm) tend to have a higher number, up to 20, of turns. The pitch of these screws corresponds to one unit cell. The screw dislocation density in these films can be measured by averaging the number of growth centers in a plurality of images taken at different locations on the same sample.

Growth rate, growth temperature, and substrate misorientation have been found to strongly influence the screw dislocation density: An increasing screw dislocation density accompanies increasing growth rate, while increasing growth temperature and substrate misorientation cause a decrease in screw dislocation density. In view of the correlation between the critical current density and the screw dislocation density, it is possible to control the critical current density of thin superconductor films by controlling one or more of the growth rate, growth temperature, and substrate misorientation parameters during manufacture of the films. Accordingly, in accordance with the invention, the occurrence and density of pinning sites, specifically screw dislocations, in high-$T_c$ superconductor films is controlled through appropriately varying the parameters of the growth process of the high-$T_c$ superconductor material, viz. growth rate, substrate temperature, and orientation of the substrate surface with respect to the crystallographic plane of the substrate.

While the following description will, for convenience, focus on the growth of $YBa_2Cu_3O_{7-\delta}$ films, as this material is the one best investigated so far, those skilled in the art will appreciate that the inventive features are likewise applicable to other high-$T_c$ superconductor materials as well.

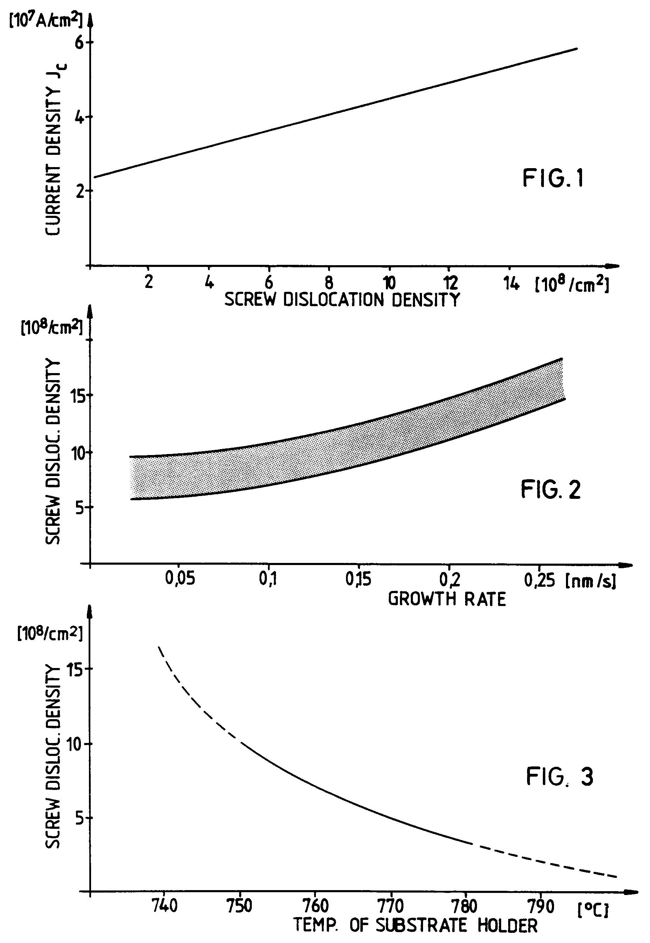

Fig. 1 shows the dependence of the critical current density, i.e. the maximum current density a superconductor (in casu $YBa_2Cu_3O_{7-\delta}$ on a $SrTiO_3$ substrate) can tolerate before it loses its superconductive character and becomes resistive, on the density of screw dislocations, for the case of no magnetic field, at 4,2 K. Obviously, to arrive at a superconductor material that can carry the highest possible current, one will wish to increase the density of the screw dislocations to its maximum. Yet there may be applications where it is desirable to have the superconductor film automatically turn conductive at a certain current flowing through it, and this threshold can, in accordance with the invention, be easily controlled by way of-setting the critical current density to an appropriate value, during the manufacture of the device.

To obtain an impression regarding the desired increase in critical current density $J_c$ through the generation of dislocations, the maximum core pinning force

$$f_p^{max}$$

per unit length, on a flux line paralleling a dislocation, at a temperature of 4,2 K can be roughly estimated as

$$f_p^{max}(T) = \frac{\Phi_0^2}{16\pi\mu_0\lambda^2(T)\,\xi(T)} \simeq 2{,}3\times 10^{-3}\,\frac{N}{m}\ ,$$

where $\Phi_0 = 2\times 10^{-15}$ Vs is the magnetic flux quantum, $\mu_0 = 4\pi\times 10^{-7}$ NA$^{-2}$ is the permeability of the vacuum, $\lambda(T) \simeq 150$ nm is the magnetic penetration depth and $\xi(T) \simeq 1{,}2$ nm is the coherence length, all values for a YBa$_2$Cu$_3$O$_{7-\delta}$ film. The equation describes the ideal case in which the order parameter of the superconductor drops to zero at the dislocation core and rises to its full value within $\xi$.

In practice, of course, these ideal pinning conditions do not always prevail. Yet for c-axis-oriented YBa$_2$Cu$_3$O$_{7-\delta}$ films at 4,2 K in magnetic fields parallel to the c-axis a pinning force $f_p \simeq 1\times 10^{-3}$ N/m was determined. In the critical state, $f_p$ equals the Lorentz force $f_L$ per unit length at the critical current density $J_c$. For $J_c = 5\times 10^7$ A/cm$^2$. :

$$f_L = J_c\Phi_0 = 10^{-3}\ \text{N/m, or}$$

$$f_p \simeq 1/2\,f_p^{max}\ .$$

This means that pinning at dislocations may account for the observed critical current densities in magnetic fields below about 200 G. Experiments have shown, however, that in magnetic fields above 200 G, the flux line density exceeds the dislocation density so that the behavior of the current density $j_c$ in high magnetic fields ($J_c(2T) \simeq J_c(0T)/2$, $J_c(8T) \simeq J_c(0T)/4$) cannot be explained by the observed screw dislocations alone, but would rather be consistent with a total line defect density (e.g., edge dislocations) of $\simeq 5\times 10^{10}$/cm$^2$, or an even higher point defect concentration.

The description will first turn to the dependence of the dislocation density on the variation of the growth rate. Fig. 2 is a diagram showing the dependence of the screw dislocation density on the growth rate during epitaxial deposition of the superconductor material. The diagram is based on scatter of experimental data, and because of the measurement and sample conditions, the measured values come to lie within a band rather than on a monotonously rising curve. At small growth rates, the superconductor material grows rather homogeneously, while with increasing growth rate the density of dislocations increases, too.

The adjustment of the growth rate is performed through the setting of the sputtering current to a value within the range between 260 mA and 500 mA, so that the corresponding growth rate assumes a value within the range of 0,01 nm/s and 0,5 nm/s.

An even more dramatic effect on the screw dislocation density is obtained by varying the growth temperature: A change of the dislocation density in excess of one order of magnitude occurs upon varying the temperature of the substrate holder, or heater block, on which the substrate is arranged, during crystal growth.

Fig. 3 shows that in the neighborhood of the usual sputtering temperature, i.e. at about 750°C, a considerable dependence of the density of screw dislocations on the temperature exists. With the other growth parameters being kept constant, the adjustment of the heater block temperature to 780°C during growth of the superconductor thin film will yield on the order of $3\times 10^8$ screw dislocations per square centimeter, whereas at a heater block temperature of 750°C, a screw dislocation density of about $12\times 10^8$/cm$^2$ is obtained.

It is, thus, possible to increase the critical current density $J_c$ to very large values by setting the heater block temperature to the appropriate value within the range between 700° and 800°C, and thus generating the corresponding number of screw dislocations which are, in turn, responsible for the critical current density $J_c$. While this temperature range is appropriate for YBa$_2$Cu$_3$O$_{7-\delta}$ films, other perovskite-related materials may require a different temperature range, up to 1020°, for example, for controlling the critical current density $J_c$.

The description now turns to the orientation of the substrate during growth of the high-$T_c$ superconductor as it has turned out to significantly influence the screw dislocation density. The growing of superconductor crystals involves an appropriate orientation of the substrate (100) surface. It has been found that with correct orientation the screw dislocation density in the superconductor material is greatest. The SrTiO$_3$

substrates (and, of course, other substrates as well) obtained from suppliers usually have their surfaces misoriented by up to 8° from the nominal (100) orientation, however. It is, therefore, essential that the orientation of the substrate surface be correct to a high standard lest a considerable reduction of the dislocation density should occur.

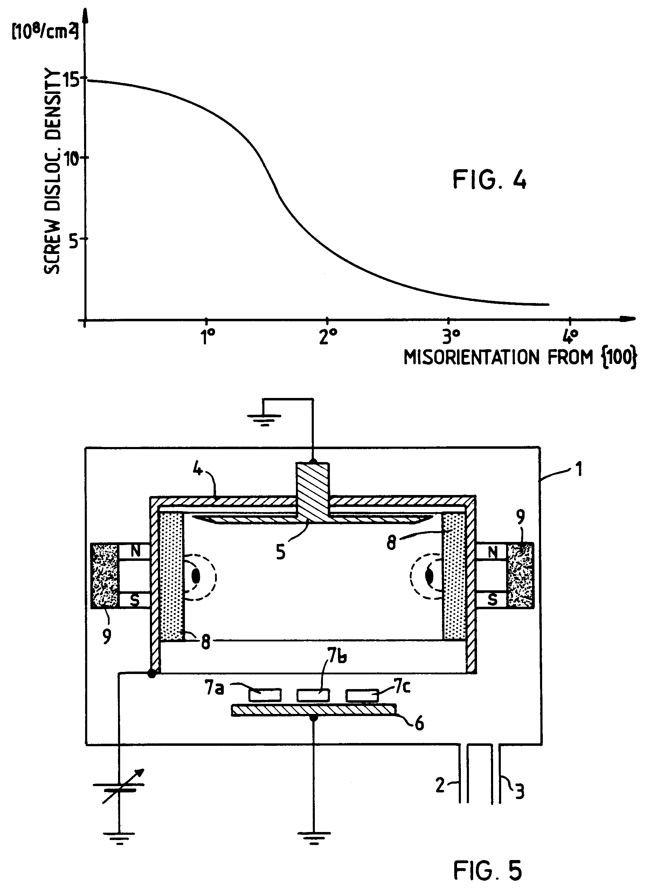

Fig. 4 shows the screw dislocation density versus the tilting angle. It can be seen from the diagram that the density of screw dislocations drastically decreases with increasing tilt angle. The curve becomes relatively flat for angles above 3°; however, even for large tilt angles the dislocation density of the superconductor material remains greater than that of the substrate material by several orders of magnitude.

For the growth of *semiconductor* crystals it is known from US-A-4,707,216 to compensate the dislocations occurring owing to the great (4%) lattice mismatch existing in connection with the epitaxial deposition of semiconductor material, such as gallium arsenide, onto a substrate of different material, such as silicon, by tilting the {100} crystallographic surface in the ⟨001⟩ direction. The aim of this reference is, by misorientation of the substrate, to *minimize* the dislocations within the semiconductor layers as they occur owing to the relatively great lattice mismatch between the silicon substrate and the gallium arsenide overlayers.

In connection with the superconductor materials relevant to the present invention, the situation is entirely different: Rather than minimizing the number of dislocations, one would like to be able to control their number up to the maximum possible. This maximum is reached at zero tilt, as shown in Fig. 4. Since the current density $J_c$ of the superconductor material increases monotonically with the dislocation density, see Fig. 1, the current density of the superconductor materials can be controlled through substrate surface tilting. Accordingly, the surface of the substrate may be tilted slightly with respect to its (100) orientation. The tilting may be made towards the ⟨111⟩ or towards the ⟨100⟩ direction. The tilt angle for the substrate may vary between 0,1° and 45° depending on the characteristics of the substrate and superconductor materials. The appropriate angle can be estimated from Figs. 1 and 4 so that the critical current density $J_c$ can be adapted to the specific application needs.

The adjustment of the substrate tilt angle is performed by first determining the amount of the misorientation of the substrate surface onto which the deposition of the superconductor overlayer is to be made, mounting the substrate with a tilt according to the desired orientation or misorientation, as the case may be, for grinding, grinding and polishing the tilted surface of the substrate so that the said surface assumes the desired tilting angle.

Fig. 5 is a schematic cross sectional view of a sputtering chamber for the epitaxial growth of superconductor thin films in accordance with the invention. Within the chamber 1 having evacuation tubing 2 and a gas inlet 3, there is arranged a cylindrical vessel 4 forming the cathode of the sputter apparatus. In the upper part of vessel 4 there is mounted an anode 5 which is, of course, appropriately insulated from vessel 4. A substrate holder 6 is provided opposite said anode 5 to receive a plurality of substrates 7a...7c. Further inside vessel 4 there is arranged an annular target 8 consisting of the superconductor material which is to be sputtered onto substrates 7a...7c. Surrounding vessel 4 is a strong permanent magnet assembly 9. Vessel 4 is connected to the negative terminal of a controllable voltage source 10 which has its positive terminal grounded. Anode 5 as well as substrate holder 6 are connected to ground.

In operation, the substrates 7a...7c are placed on substrate holder 6 which is heated to the appropriate process temperature after chamber 1 was evacuated and filled with the Ar/O gas atmosphere. With the sputter voltage adjusted to the selected value, a gas discharge will develop resulting in a plasma ring attaching to the inside of vessel 4 opposite the position of ring magnet assembly 9. The ionized argon atoms will now bombard target 8 and remove superconductor molecules from it which are deposited onto substrates 7a...7c (inter alia).

As mentioned before, the sputter voltage can be adjusted such that a predetermined growth rate is obtained for the superconductor material.

## Claims

1. Method for controlling the current density tolerance of high-$T_c$ superconductors through the introduction into the superconductor material of a predetermined number of dislocations and associated pinning centers within the lattice of the superconductor material through appropriate adjustment of certain growth parameters thereof, *characterized* by providing a crystalline substrate (7a...7c), said substrate (7a...7c) having a low-index crystallographic surface onto which the high-$T_c$ superconductor material is to be epitaxially grown, and by adjusting one or more of the parameters growth rate, growth temperature and substrate tilt angle, respectively, to a constant value during the growth of the superconductor crystal, while keeping all of the other growth parameters at their set values.

2. Method in accordance with claim 1, *characterized* in that the predetermined number of dislocations within the lattice of the superconductor material is generated through appropriate adjustment of the superconductor crystal growth rate to a value within the range between 0 and 1 $\mu$m/s.

3. Method in accordance with claim 1, *characterized* in that the predetermined number of dislocations within the lattice of the superconductor material is generated through appropriate adjustment of the growth temperature to a value in the range between 400°C and 1020°C.

4. Method in accordance with claim 1, *characterized* in that the predetermined number of dislocations within the lattice of the superconductor material is generated through appropriate adjustment of the substrate tilt angle to a value within the range between 0° and 45°.

5. Method in accordance with claim 1, *characterized* in that the predetermined number of dislocations within the lattice of the superconductor material is generated through appropriate adjustment of the growth rate to a value within the range between 0 and 1 $\mu$m/s and of the growth temperature to a value within the range between 400°C and 1020°C.

6. Method in accordance with claim 1, *characterized* in that the predetermined number of dislocations within the lattice of the superconductor material is generated through appropriate adjustment of the growth temperature to a value within the range between 400°C and 1020°C and of the substrate tilt angle to a value within the range between 0° and 45°.

7. Method in accordance with claim 1, *characterized* in that the predetermined number of dislocations within the lattice of the superconductor material is generated through appropriate adjustment of the growth rate to a value within the range between O and 1 $\mu$m/s and of the substrate tilt angle to a value within the range between 0° and 45°.

8. Method in accordance with claim 1, *characterized* in that the predetermined number of dislocations within the lattice of the superconductor material is generated through appropriate adjustment of the growth rate to a value within the range between 0 and 1 $\mu$m/s, of the growth temperature to a value in the range between 400°C and 1020°C, and of the substrate tilt angle to a value in the range between 0° and 45°.

9. Method in accordance with any one of claims 2, 5, 7 or 8, *characterized* in that the adjustment of the growth rate is performed through the controlling of the sputtering current to a value in the range between 260 mA and 500 mA.

10. Method in accordance with any one of claims 3, 5, 6 or 8, *characterized* in that the adjustment of the growth temperature is performed through the heating of the substrate holder (6) to a temperature within the range between 400°C and 1020°C.

11. Method in accordance with any one of claims 4, 6, 7 or 8, *characterized* in that the adjustment of the substrate tilt angle is performed by determining the value of the misorientation of the substrate surface onto which the deposition of the superconductor overlayer is to be made, mounting the substrate with a tilt according to the desired orientation/misorientation for grinding, grinding and polishing the tilted surface of the substrate so that the said surface assumes the desired tilting angle.

12. Method in accordance with any one of claims 4, 6, 7, 8, or 11, *characterized* in that the tilting of the substrate surface is performed towards the ⟨111⟩ direction.

13. Method in accordance with any one of claims 4, 6, 7, 8, or 11, **characterized** in that the tilting of the substrate surface is performed towards the ⟨100⟩ direction.

14. Method in accordance with any one of claims 4, 6, 7, 8, or 11, *characterized* in that the tilting of the substrate surface is performed towards the ⟨100⟩ and ⟨111⟩ directions at the same time.

FIG.1

CURRENT DENSITY $J_c$ — $[10^7 A/cm^2]$

SCREW DISLOCATION DENSITY — $[10^8/cm^2]$

FIG. 2

SCREW DISLOC. DENSITY — $[10^8/cm^2]$

GROWTH RATE — [nm/s]

FIG. 3

SCREW DISLOC. DENSITY — $[10^8/cm^2]$

TEMP. OF SUBSTRATE HOLDER — [°C]

FIG. 4

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 414 205 (MATSUSHITA)<br>* column 3, line 37 - column 4, line 33 *<br>* column 11, line 31 - line 55 *<br>* column 15, line 18 - line 57 *<br>* column 24, line 11 - line 42 *<br>--- | 1-3,5,10 | H01L39/24 |
| A | IEEE TRANSACTIONS ON MAGNETICS<br>vol. 25, no. 5, September 1989, NEW YORK, US<br>pages 3218 - 3220;<br>T.R.McGuire et al: 'Magnetic Properties and Critical Currents of Epitaxial YBa2Cu307-x Films'<br>& PROCEEDINGS INTERNATIONAL MAGNETICS CONFERENCE, 28 March 1989, Washington, US<br>* page 3218, paragraph 1 -paragraph 3 *<br>* page 3219, paragraph 2 -paragraph 3 *<br>--- | 1 | |
| D,X | NATURE<br>vol. 350, no. 6316, 28 March 1991, BASINGSTOKE, UK<br>pages 279 - 280;<br>Gerber C. et al: 'Screw dislocations in high Tc films'<br>full article<br>--- | 1-3,5,10 | TECHNICAL FIELDS SEARCHED (Int. Cl.5)<br><br>H01L |
| P,X | PHYSICA C<br>, vol.185-189, pt.3, December 1991, pages 2007-8, Amsterdam, NL & MATERIALS AND MECHANISMS OF SUPERCONDUCTIVITY CONFERENCE, 22-26 July 1991, Kanazawa, JP; Schlom D. et al: "Observations of screw dislocations in sputtered YBa2Cu307- films"<br>full article<br>----- | 1,3-4,6 10,13-14 | |

The present search report has been drawn up for all claims

| Place of search | Date of completion of the search | Examiner |
|---|---|---|
| THE HAGUE | 20 JANUARY 1992 | HAMMEL E.J. |

EPO FORM 1503 03.82 (P0401)